# EUROPEAN PATENT APPLICATION

(11) **EP 1 858 093 A2**
(43) Date of publication of application: **21.11.2007**
(21) Application number: 07009712.6
(22) Date of filing: 15.05.2007
(51) Int. Cl.: H01L 45/00

(54) **Memory cell including doped phase change material**

(30) Priority: 18.05.2006 US 436279
(71) Applicant: Qimonda North America Corp., Cary, NC 27513 (US)
(72) Inventor: Happ, Thomas, Dr., Tarrytown, NY 10591 (US)
(74) Representative: Jehle, Volker Armin

(57) **Abstract**

A phase change memory cell includes a phase change material doped with a first material having a resistivity that decreases less than one decade per 20 degrees Celsius when transitioning from an amorphous state to a crystalline state.

## Description

### Background

One type of non-volatile memory is resistive memory. Resistive memory utilizes the resistance value of a memory element to store one or more bits of data. For example, a memory element programmed to have a high resistance value may represent a logic "1" data bit value, and a memory element programmed to have a low resistance value may represent a logic "0" data bit value. The resistance value of the memory element is switched electrically by applying a voltage pulse or a current pulse to the memory element. One type of resistive memory is phase change memory. Phase change memory uses a phase change material in the resistive memory element.

Phase change memories are based on phase change materials that exhibit at least two different states. Phase change material may be used in memory cells to store bits of data. The states of phase change material may be referred to as amorphous and crystalline states. The states may be distinguished because the amorphous state generally exhibits higher resistivity than does the crystalline state. Generally, the amorphous state involves a more disordered atomic structure, while the crystalline state involves a more ordered lattice. Some phase change materials exhibit more than one crystalline state, e.g. a face-centered cubic (FCC) state and a hexagonal closest packing (HCP) state. These two crystalline states have different resistivities and may be used to store bits of data. In the following description, the amorphous state generally refers to the state having the higher resistivity, and the crystalline state generally refers to the state having the lower resistivity.

Phase change in the phase change materials may be induced reversibly. In this way, the memory may change from the amorphous state to the crystalline state and from the crystalline state to the amorphous state in response to temperature changes. The temperature changes to the phase change material may be achieved in a variety of ways. For example, a laser can be directed to the phase change material, current may be driven through the phase change material, or current can be fed through a resistive heater adjacent the phase change material. In any of these methods, controllable heating of the phase change material causes controllable phase change within the phase change material.

A phase change memory including a memory array having a plurality of memory cells that are made of phase change material may be programmed to store data utilizing the memory states of the phase change material. One way to read and write data in such a phase change memory device is to control a current and/or a voltage pulse that is applied to the phase change material. The level of current and/or voltage generally corresponds to the temperature induced within the phase change material in each memory cell.

To achieve higher density phase change memories, a phase change memory cell can store multiple bits of data. Multi-bit storage in a phase change memory cell can be achieved by programming the phase change material to have intermediate resistance values or states. Cells in such intermediate states have a resistance that lies between the fully crystalline state and the fully amorphous state. If the phase change memory cell is programmed to one of three different resistance levels, 1.5 bits of data per cell can be stored. If the phase change memory cell is programmed to one of four different resistance levels, two bits of data per cell can be stored, and so on. For simplicity, the description in this disclosure is substantially focused on four different resistance levels or states and two bits of data per cell. This is for illustrative purposes only, however, and not intended to limit the scope of the invention. In principle it is possible to store three or more states.

To program a phase change memory cell to an intermediate resistance value, the amount of crystalline material coexisting with amorphous material and hence the cell resistance is controlled via a suitable write strategy. The amount of crystalline material coexisting with amorphous material should be precisely controlled to ensure consistent resistance values for multi-bit storage. Consistent resistance values having a narrow distribution of the different resistance levels ensure that a sufficient sensing margin can be obtained.

For these and other reasons, there is a need for the present invention.

### Summary

One embodiment of the present invention provides a phase change memory cell. The phase change memory cell includes a phase change material doped with a first material having a resistivity that decreases less than one decade per 20 degrees Celsius when transitioning from an amorphous state to a crystalline state.

### Brief Description of the Drawings

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Figure 1 is a block diagram illustrating one embodiment of a memory device.
Figure 2 is a diagram illustrating one embodiment of a memory cell in four different states.
Figure 3 is a graph illustrating one embodiment of resistivity versus temperature for nitrogen doped GeSbTe obtained at a 1 K/s ramp rate.
Figure 4 is a graph illustrating one embodiment of resistivity versus temperature for silicon doped GeSbTe obtained at a 1 K/s ramp rate.
Figure 5 is a graph illustrating one embodiment of resistivity versus temperature for nitrogen doped AgInSbTe obtained at a 1K/s ramp rate.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

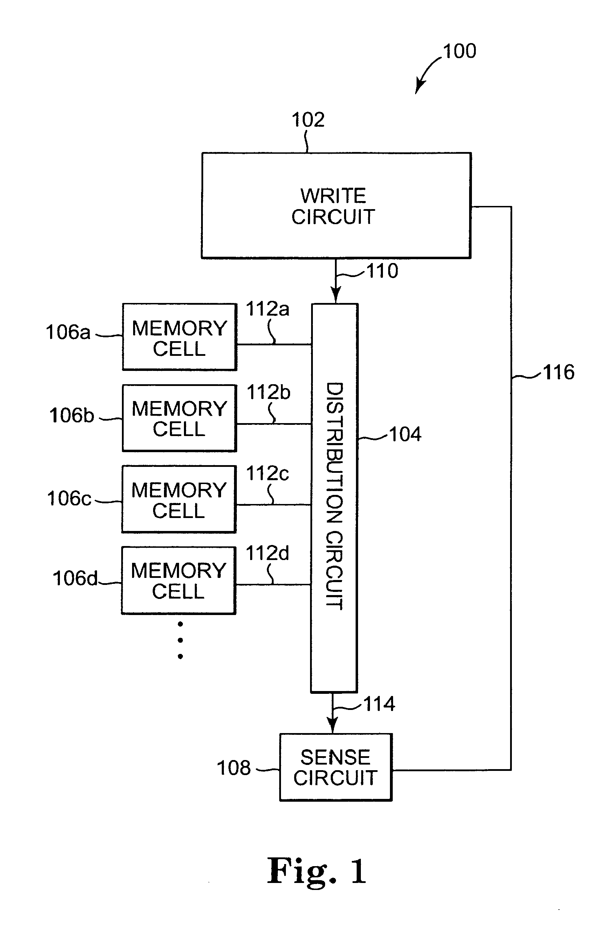

Figure 1 is a block diagram illustrating one embodiment of a memory device 100. Memory device 100 includes a write circuit 102, a distribution circuit 104, memory cells 106a, 106b, 106c, and 106d, and a sense circuit 108. Each of the memory cells 106a-106d is a phase change memory cell that stores data based on the amorphous and crystalline states of phase change material in the memory cell. Also, each of the memory cells 106a-106d can be programmed into more than two states by programming the phase change material to have intermediate resistance values. To program one of the memory cells 106a-106d to an intermediate resistance value, the amount of crystalline material coexisting with amorphous material - and hence the cell resistance - is controlled via a suitable write strategy.

Phase change memory cells 106a-106d include highly doped phase change material for providing multi-bit or multi-level phase change memory cells. By increasing the doping level of the phase change material, the typically very steep and abrupt transition between the amorphous state and the crystalline state of the phase change material becomes less steep and less abrupt over a relatively wide temperature range. The slope of resistivity versus temperature for the doped phase change material is reduced compared to phase change material that is not doped. The reduced slope allows more precise control over the desired resistance settings of each phase change memory cell 106a-106d. The reduced slope is particularly useful for programming the intermediate resistance levels for the multi-bit phase change memory cells. In one embodiment, the resistivity of the doped phase change material decreases less than one decade (on a log scale) per 20 degrees Celsius at a temperature ramp rate less than or equal to 1 Kelvin per second. In other embodiments, the resistivity of the doped phase change material decreases less than one decade per 30 degrees Celsius or less than one decade per 40 degrees Celsius.

In addition, the overall crystallization point of the doped phase change material is shifted to significantly higher temperatures, which increases the operating window for reading the phase change memory cells and improves the high temperature storage performance of the phase change memory cells. The increased operating window is advantageous for multi-bit phase change memory cell storage since the read current of the intermediate resistance states is higher than for the lowest resistance amorphous state. The higher read current poses a larger risk of inducing further crystallization due to heating by the read current. In addition, using a phase change material with increased crystallization temperature is therefore beneficial to the read performance of the memory, since higher read currents and hence stronger thermal disturb of the intermediate states can be tolerated.

The increased crystallization temperature of the phase change material corresponds to a prolonged crystallization time at a given temperature below the crystallization temperature. On the low end of the temperature scale this prolonged crystallization improves data retention, whereas it also allows improved control over the crystallization process during the SET program operation. With a slower crystallization speed, better control over crystallization can be obtained by controlling the duration of the SET pulse.

Write circuit 102 is electrically coupled to distribution circuit 104 through signal path 110. Distribution circuit 104 is electrically coupled to each of the memory cells 106a-106d through signal paths 112a-112d. Distribution circuit 104 is electrically coupled to memory cell 106a through signal path 112a. Distribution circuit 104 is electrically coupled to memory cell 106b through signal path 112b. Distribution circuit 104 is electrically coupled to memory cell 106c through signal path 112c. Distribution circuit 104 is electrically coupled to memory cell 106d through signal path 112d. In addition, distribution circuit 104 is electrically coupled to sense circuit 108 through signal path 114, and sense circuit 108 is electrically coupled to write circuit 102 through signal path 116.

Each of the memory cells 106a-106d includes the doped phase change material that may be changed from an amorphous state to a crystalline state or from a crystalline state to an amorphous state under the influence of temperature change. The amount of crystalline material coexisting with amorphous material in the doped phase change material of one of the memory cells 106a-106d thereby defines more than two states for storing data within memory device 100. In the amorphous state, a phase change material exhibits significantly higher resistivity than in the crystalline state. Therefore, the more than two states of memory cells 106a-106d differ in their electrical resistivity. In one embodiment, the more than two states can be three states and a trinary system can be used, wherein the three states are assigned bit values of "0", "1", and "2". In one embodiment, the more than two states are four states that can be assigned multi-bit values, such as "00", "01", "10", and "11". In other embodiments, the more than two states can be any suitable number of states in the phase change material of a memory cell.

Write circuit 102 provides pulses to memory cells 106a-106d and programs one of the more than two resistance levels or states into the phase change material of each of the memory cells 106a-106d. In one embodiment, write circuit 102 provides voltage pulses to distribution circuit 104 through signal path 110 and distribution circuit 104 controllably directs the voltage pulses to memory cells 106a-106d through signal paths 112a-112d. In one embodiment, distribution circuit 104 includes a plurality of transistors that controllably direct voltage pulses to each of the memory cells 106a-106d. In other embodiments, write circuit 102 provides current pulses to distribution circuit 104 through signal path 110 and distribution circuit 104 controllably directs the current pulses to memory cells 106a-106d through signal paths 112a-112d.

Sense circuit 108 senses the state of each memory cell and provides signals that indicate the state of the resistance of each memory cell. Sense circuit 108 reads each of the more than two states of memory cells 106a-106d through signal path 114. Distribution circuit 104 controllably directs read signals between sense circuit 108 and memory cells 106a-106d through signal paths 112a-112d. In one embodiment, distribution circuit 104 includes a plurality of transistors that controllably direct read signals between sense circuit 108 and memory cells 106a-106d.

In operation of one embodiment, write circuit 102 resets the phase change material in memory cells 106a-106d. A reset operation includes heating the phase change material of the target memory cell above its melting temperature and quickly cooling the phase change material to thereby achieve a substantially amorphous state. This amorphous state is one of the more than two states of each of the memory cells 106a-106d and is the highest resistance state.

Write circuit 102 programs a selected one of the more than two states into a selected one of the memory cells 106a-106d. Write circuit 102 provides a signal to the selected one of the memory cells 106a-106d to crystallize part of the phase change material and thereby lower the resistance of the selected one of the memory cells 106a-106d.

In operation of another embodiment, write circuit 102 sets the phase change material in memory cells 106a-106d. A set operation includes heating the phase change material above its crystallization temperature (but usually below its melting temperature) to thereby achieve a substantially crystalline state. This crystalline state is one of the more than two states of each of the memory cells 106a-106d and is the lowest resistance state.

Write circuit 102 programs a selected one of the more than two states into a selected one of the memory cells 106a-106d. Write circuit 102 provides a signal to the selected one of the memory cells 106a-106d to partially crystallize the phase change material and thereby lower the resistance of the selected one of the memory cells 106a-106d.

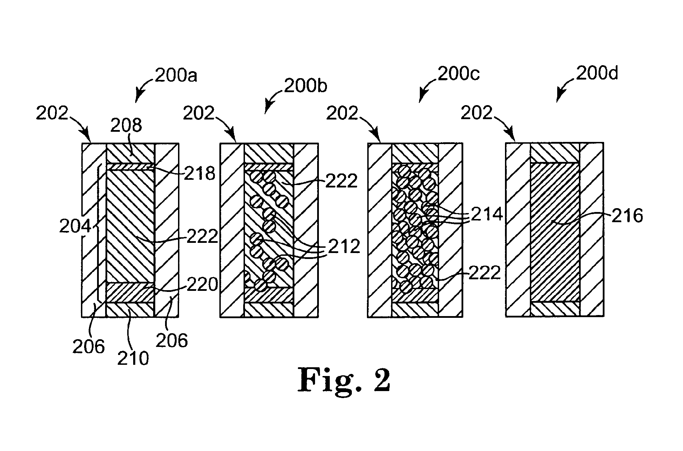

Figure 2 is a diagram illustrating one embodiment of a memory cell 202 in four different states at 200a, 200b, 200c, and 200d. Memory cell 202 includes a doped phase change material 204 that is situated in insulation material 206. In other embodiments, memory cell 202 can have any suitable geometry including doped phase change material 204 in any suitable geometry and insulation material 206 in any suitable geometry.

Doped phase change material 204 is electrically coupled at one end to a first electrode 208 and at the other end to a second electrode 210. Pulses are provided to memory cell 202 via first electrode 208 and second electrode 210. The current path through doped phase change material 204 is from one of the first electrode 208 and second electrode 210 to the other one of the first electrode 208 and second electrode 210. In one embodiment, each of the memory cells 106a-106d is similar to memory cell 202. Memory cell 202 provides a storage location for storing bits of data.

Insulation material 206 can be any suitable insulator, such as SiO₂, fluorinated silica glass (FSG), or boro-phosphorous silicate glass (BPSG). First electrode 208 and second electrode 210 can be any suitable electrode material, such as TiN, TaN, W, AI, Ti, Ta, TiSiN, TaSiN, TiAIN, TaAlN, or Cu.

Doped phase change material 204 may include phase change material made up of a variety of materials in accordance with the present invention. Generally, chalcogenide alloys that contain one or more elements from group VI of the periodic table are useful as such materials. In one embodiment, the phase change material of memory cell 202 is made up of a chalcogenide compound material, such as GeSbTe, SbTe, GeTe, or AgInSbTe. In another embodiment, the phase change material is chalcogen free, such as GeSb, GaSb, InSb, or GeGaInSb. In other embodiments, the phase change material is made up of any suitable material including one or more of the elements Ge, Sb, Te, Ga, As, In, Se, and S.

The phase change material is doped with N, Si, O, another suitable material, or combinations thereof. In one embodiment, doped phase change material 204 includes one or more of GeSb, InSb, AgSb, GaSb, SbTe, SbZn, SbSn, SbAs, and SbSe doped with one or more of N, Si, O, or another suitable material. In another embodiment, doped phase change material 204 includes one or more of GeSbTe, SbTeIn, SbTeAg, SbTeGa, SbTeZn, SbTeSn, SbTeAs, and SbTeSe doped with one or more of N, Si, O, or another suitable material. The doping level is varied to provide the desired slope for resistivity versus temperature.

Doped phase change material 204 is programmed into one of four states to store two bits of data. A selection device, such as an active device like a transistor or diode, is coupled to first electrode 208 to control the application of pulses to doped phase change material 204. The pulses reset doped phase change material 204 and program one of the other three states into doped phase change material 204. At 200b, a small fraction 212 of doped phase change material 204 has been programmed to change the resistance through doped phase change material 204 and memory cell 202. At 200c, a medium sized fraction 214 of doped phase change material 204 has been programmed to change the resistance through doped phase change material 204 and memory cell 202. At 200d, a large fraction 216, which is substantially all of doped phase change material 204, has been programmed to change the resistance through doped phase change material 204 and memory cell 202.

The size of the programmed fraction is related to the resistance through doped phase change material 204 and memory cell 202. The three different phase change fractions at 200b-200d plus the initial state at 200a provide four states in doped phase change material 204, and memory cell 202 provides a storage location for storing two bits of data. In one embodiment, the state of memory cell 202 at 200a is a "00", the state of memory cell 202 at 200b is a "01", the state of memory cell 202 at 200c is a "10", and the state of memory cell 202 at 200d is a "11".

At 200a, doped phase change material 204 is reset to a substantially amorphous state. During a reset operation of memory cell 202, a reset pulse is selectively enabled by the selection device and sent through first electrode 208 and doped phase change material 204. The reset pulse heats doped phase change material 204 above its melting temperature and doped phase change material 204 is quickly cooled to achieve the substantially amorphous state at 200a. After a reset operation, doped phase change material 204 includes crystalline state phase change material at 218 and 220, and amorphous state phase change material at 222. The substantially amorphous state at 200a is the highest resistance state of memory cell 202.

To program doped phase change material 204 into one of the other three states 200b-200d, a pulse is provided via a write circuit, such as write circuit 102. At 200b, a pulse is provided to program the small volume fraction 212 into a crystalline state. The crystalline state is less resistive than the amorphous state and memory cell 202 at 200b has a lower resistance than memory cell 202 in the substantially amorphous state at 200a. The partially crystalline and partially amorphous state at 200b is the second highest resistance state of memory cell 202.

At 200c, a pulse is provided to program the medium volume fraction 214 into a crystalline state. Since the crystalline fraction 214 is larger than the crystalline faction 212 and the crystalline state is less resistive than the amorphous state, memory cell 202 at 200c has a lower resistance than memory cell 202 at 200b and memory cell 202 in the amorphous state at 200a. The partially crystalline and partially amorphous state at 200c is the second lowest resistance state of memory cell 202.

At 200d, a pulse is provided to program substantially all of the phase change material 216 into the crystalline state. Since the crystalline state is less resistive than the amorphous state, memory cell 202 at 200d has a lower resistance than memory cell 202 at 200c, memory cell 202 at 200b, and memory cell 202 in the amorphous state at 200a. The substantially crystalline state at 200d is the lowest resistance state of memory cell 202. In other embodiments, memory cell 202 can be programmed into any suitable number of resistance values or states. In other embodiments, memory cell 202 can be set to a substantially crystalline state and reset pulses can be used to program memory cell 202 to the desired resistance value or state.

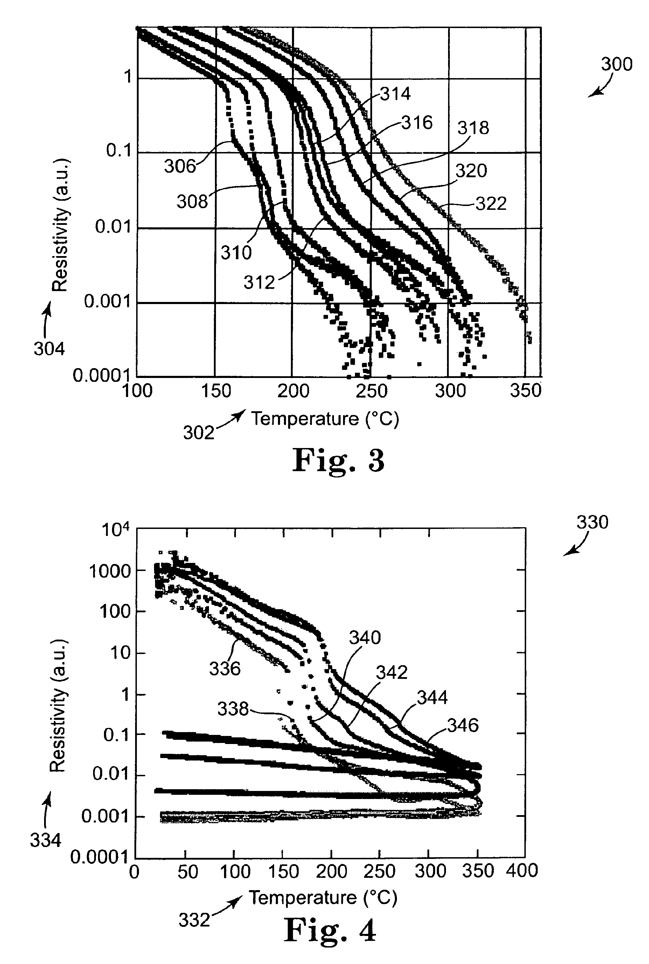

Figure 3 is a graph 300 illustrating one embodiment of resistivity versus temperature for nitrogen doped GeSbTe obtained at a 1K/s ramp rate. Graph 300 includes temperature in degrees Celsius on x-axis 302 and resistivity on a log scale on y-axis 304. GeSbTe, such as Ge₂Sb₂Te₅, with no nitrogen doping is indicated at 306. GeSbTe with 2 sccm or 2.1at% nitrogen doping is indicated at 308. GeSbTe with 5 sccm or 2.5at% nitrogen doping is indicated at 310. GeSbTe with 10 sccm or 7.6at% nitrogen doping is indicated at 312. GeSbTe with 12 sccm or 9at% nitrogen doping is indicated at 314. GeSbTe with 15 sccm or 9.8at% nitrogen doping is indicated at 316. GeSbTe with 20 sccm or 12.2at% nitrogen doping is indicated at 318. GeSbTe with 25 sccm or 13.5at% nitrogen doping is indicated at 320, and GeSbTe with 30 sccm or 15.1at% nitrogen doping is indicated at 322.

At atomic doping concentrations at or above approximately 8%, such as indicated at 314, 316, 318, 320, and 322, the resistivity decreases less than approximately one decade per 20 degrees Celsius when transitioning from an amorphous state to a crystalline state. The reduced slope allows more precise setting of the intermediate resistance states, such as states 200b and 200c previously described and illustrated with reference to Figure 2.

Figure 4 is a graph 330 illustrating one embodiment of resistivity versus temperature for silicon doped GeSbTe obtained at a 1K/s ramp rate. Graph 330 includes temperature in degrees Celsius on x-axis 332 and resistivity on a log scale on y-axis 334. GeSbTe, such as Ge₂Sb₂Te₅, with no silicon doping is indicated at 336. GeSbTe doped with 1.3at% silicon is indicated at 338. GeSbTe doped with 4.8at% silicon is indicated at 340. GeSbTe doped with 6.0at% silicon is indicated at 342. GeSbTe doped with 11.5at% silicon is indicated at 344, and GeSbTe doped with 14.3at% silicon is indicated at 346.

The resistivity increases in both the amorphous and crystalline phases with an increase in the silicon doping level. At atomic doping concentrations at or above approximately 6% such as indicated at 342, 344, and 346, the resistivity decreases less than approximately one decade per 20 degrees Celsius when transitioning from an amorphous state to a crystalline state. The reduced slope allows more precise setting of the intermediate resistance states, such as states 200b and 200c previously described and illustrated with reference to Figure 2. In addition, the crystallization temperature and the resistivity of the phase change material in the crystalline phase is increased.

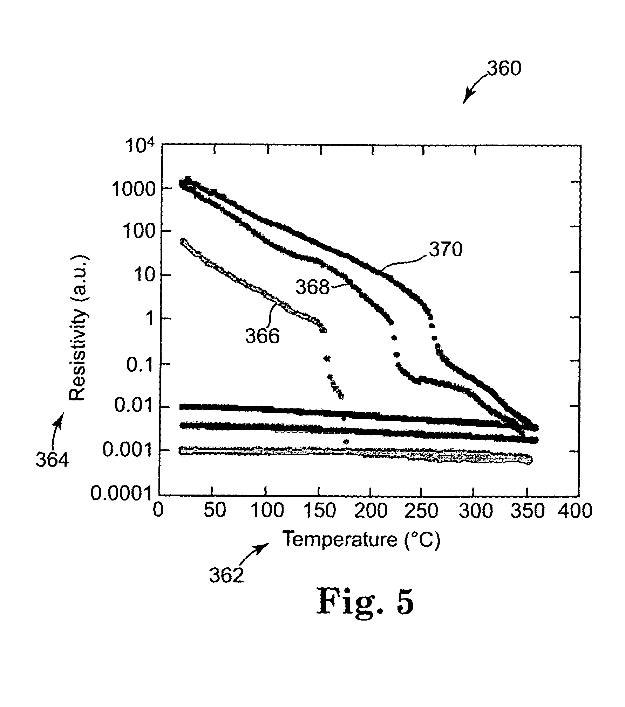

Figure 5 is a graph 360 illustrating one embodiment of resistivity versus temperatures for nitrogen doped AgInSbTe obtained at a 1 K/s ramp rate. Graph 360 includes temperature in degrees Celsius on x-axis 362 and resistivity on a log scale on y-axis 364. AgInSbTe with no nitrogen doping is indicated at 366. AgInSbTe with 10 sccm or 7.6at% nitrogen doping is indicated at 368, and AgInSbTe with 20 sccm or 12.2at% nitrogen doping is indicated at 370.

As the nitrogen doping level is increased above approximately 7at%, there is a substantial increase in the crystallization temperature and a broadening of the transition between the amorphous state phase change material and the crystalline state phase change material. The broadening of the transition allows more precise setting of the intermediate resistance states, such as states 200b and 200c previously described and illustrated with reference to Figure 2.

In other embodiments, other phase change materials and doping materials are used to provide doped phase change materials having characteristics similar to the characteristics illustrated in Figures 3-5. Embodiments of the present invention provide a doped phase change material for use in multi-level phase change memory cells. The doped phase change material reduces the slope of resistivity versus temperature and increases the crystallization temperature. The reduced slope and increased crystallization temperature enable more precise control over the programming of memory cells to intermediate resistance values for multi-bit storage applications.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A phase change memory cell comprising:
a phase change material doped with a first material having a resistivity that decreases less than one decade per 20 degrees Celsius when transitioning from an amorphous state to a crystalline state.

2. The memory cell of claim 1, wherein the phase change material has a resistivity that decreases less than one decade per 20 degrees Celsius at a temperature ramp rate less than or equal to 1 K/s.

3. The memory cell of claim 1, wherein the phase change material comprises GeSbTe.

4. The memory cell of claim 1, wherein the phase change material comprises Ge₂Sb₂Te₅.

5. The memory cell of claim 1, wherein the phase change material comprises AgInSbTe.

6. The memory cell of claim 1, wherein the phase change material comprises at least one of Ge, Sb, Te, Ga, As, In, Se, and S.

7. The memory cell of claim 1, wherein the first material comprises nitrogen.

8. The memory cell of claim 1, wherein the first material comprises silicon.

9. The memory cell of claim 1, wherein the first material comprises oxygen.

10. The memory cell of claim 1, wherein the phase change material can be programmed to at least three resistance values.

11. A memory comprising:
an array of phase change memory cells, each memory cell storing more than one bit of data and each memory cell including a phase change material doped with a first material having a resistivity that decreases no more than one decade per 20 degrees Celsius at a temperature ramp rate less than or equal to 1 K/s when transitioning from an amorphous state to a crystalline state.

12. The memory cell of claim 11, wherein the phase change material comprises at least one of Ge, Sb, Te, Ga, As, In, Se, and S.

13. The memory cell of claim 11, wherein the phase change material comprises GeSbTe.

14. The memory cell of claim 11, wherein the first material comprises one of N, Si, and O.

15. The memory cell of claim 11, wherein the phase change material is doped with the first material to a doping level greater than 8%.

16. A phase change memory cell comprising:
phase change material; and
means for controlling a resistivity of the phase change material such that the resistivity does not decrease more than one decade per 20 degrees Celsius at a temperature ramp rate less than or equal to 1K/s when transitioning from an amorphous state to a crystalline state.

17. The method of claim 16, wherein the phase change material comprises at least one of Ge, Sb, Te, Ga, As, In, Se, and S.

18. A method for fabricating a memory cell, the method comprising:
providing a phase change material; and
doping the phase change material such that a resistivity of the phase change material does not decrease more than one decade per 20 degrees Celsius when transitioning from an amorphous state to a crystalline state.

19. The method of claim 18, wherein doping the phase change material comprises doping the phase change material such that a resistivity of the phase change material does not decrease more than one decade per 20 degrees Celsius at a temperature ramp rate less than or equal to 1 K/s.

20. The method of claim 18, wherein doping the phase change material comprises doping a phase change material comprising at least one of Ge, Sb, Te, Ga, As, In, Se, and S.

21. The method of claim 18, wherein doping the phase change material comprises doping the phase change material with at least one of N, Si, and O.

22. The method of claim 18, wherein doping the phase change material comprises doping the phase change material with a doping level greater than 8%.

23. A method for fabricating a memory, the method comprising:
providing a phase change material; and
doping the phase change material for storing more than one data bit such that a resistivity of the phase change material does not decrease more than one decade per 20 degrees Celsius at a temperature ramp rate less than or equal to 1 K/s when transitioning from an amorphous state to a crystalline state.

24. The method of claim 23, wherein providing the phase change material comprises providing phase change material comprising at least one of Ge, Sb, Te, Ga, As, In, Se, and S.

25. The method of claim 23, wherein doping the phase change material comprises doping the phase change material with at least one of N, Si, and O.

26. The method of claim 23, wherein doping the phase material comprises doping the phase change memory with a doping level of at least 8%.
